# EUROPÄISCHE PATENTANMELDUNG

(11) **EP 0 954 030 A1**
(43) Veröffentlichungstag der Anmeldung: **03.11.1999**
(21) Anmeldenummer: 99106441.1
(22) Anmeldetag: 29.03.1999
(51) Int. Cl.: H01L 27/108, H01L 21/8242, H01L 21/02

(54) **Verfahren zur Herstellung eines Kondensators für eine Halbleiter-Speicheranordnung**

(30) Priorität: 30.04.1998 DE 19819576
(71) Anmelder: SIEMENS AKTIENGESELLSCHAFT, 80333 München (DE)
(72) Erfinder: Franosch, Martin, 81739 München (DE); Lange, Gerrit, Dr., 81373 München (DE); Schäfer, Herbert, Dr., 85635 Höhenkirchen-Siegertsbrunn (DE); Stengl, Reinhard, Dr., 86391 Stadtbergen (DE); Reisinger, Hans, Dr., 82031 Grünwald (DE); Wendt, Hermann, Dr., 85630 Grasbrunn (DE); Lehmann, Volker, Dr., 80689 München (DE)

(57) **Zusammenfassung**

Die Erfindung betrifft ein Verfahren zum Herstellen eines Kondensators für eine Halbleiter-Speicheranordnung. Dabei wird auf eine leitfähige Unterlage, die über ein Kontaktloch (3) in einer Isolatorschicht (2) mit einem Halbleiterkörper (1) verbunden ist, selektiv ätzbares Material aufgebracht und strukturiert. Darauf wird eine erste leitfähige Schicht (6) aufgebracht und strukturiert. In die erste leitfähige Schicht (6) wird ein Loch eingebracht, durch das das selektiv ätzbare Material herausgeätzt wird. Dabei entsteht unter der ersten leitfähigen Schicht (6) ein Hohlraum. Die Innenfläche des Hohlraumes und die Außenfläche der ersten leitfähigen Schicht (6) werden mit einer dielektrischen Schicht (9) versehen, auf die eine zweite leitfähige Schicht (10) aufgetragen und strukturiert wird.

## Beschreibung

Die vorliegende Erfindung betrifft ein Verfahren zur Herstellung eines Kondensators für eine HalbleiterSpeicheranordnung.

In Halbleiter-Speicheranordnungen, wie beispielsweise DRAMs (dynamischer Randomspeicher) oder FRAMs (ferroelektrischer Randomspeicher), soll die von einem Speicherkondensator eingenommene Fläche möglichst klein sein, wobei der Speicherkondensator aber eine Mindestkapazität nicht unterschreiten soll. Zur Erreichung dieses Zieles wurden bereits vielfältige Anstrengungen unternommen, um Kondensatoren zu schaffen, die dieser Forderung genügen.

Als Beispiele für die bisher bekannten verschiedenen Kondensatortypen soll auf folgendes verwiesen werden:
In der DE 195 46 999 C1 ist eine sogenannte FIN-Stapelzelle beschrieben, bei der unter Ausnutzung der selektiven Ätzbarkeit von p⁺-dotiertem Polysilizium und p⁻-dotiertem Polysilizium eine lamellenartige Struktur aus p⁺-leitendem Polysilizium erzeugt wird, auf die nach Auftragen einer Isolierschicht eine Gegenelektrode aufgebracht wird. Die im wesentlichen waagrecht verlaufenden Lamellen tragen erheblich zur Steigerung der Kapazität eines solchen Kondensators bei. Wird aber der von dem Kondensator eingenommene Platz auf einer integrierten Schaltung immer kleiner, so verringert sich der Beitrag der Lamellen zur Kapazität überdurchschnittlich.

Weiterhin ist aus der US 5 196 364 ein Stapelkondensator bekannt, bei dem eine Elektrode fingerförmig gestaltet und unter Zwischenfügung einer Kondensatorschicht mit einer Gegenelektrode überzogen ist. Die Finger sind dabei nach außen gespreizt, was zwar die Kapazität eines solchen Kondensators erhöht, jedoch gleichzeitig auch dessen Platzbedarf auf einer integrierten Schaltung steigert.

Während die beiden oben beschriebenen bekannten Kondensatoren auf einer integrierten Schaltung angebracht sind, ist ein aus IEDM 85, Seiten 702 bis 705, bekannter Grabenkondensator in einen Halbleiterchip eingebettet, wobei die eine Elektrode eines solchen Grabenkondensators durch den Graben auffüllen-des Polysilizium gebildet ist, das von dem als Gegenelektrode wirkenden Halbleiterchip durch eine Isolierschicht aus beispielsweise Siliziumdioxid getrennt ist.

Aus der US 5 095 346 ist eine sogenannte fortgeschrittene Blockzelle für einen Stapelkondensator bekannt, in der zwei polykristalline Siliziumschichten, die Speicherelektroden bilden, miteinander kapazitiv verbunden sind. Die jeweiligen Schichten werden dabei durch Ätzen strukturiert.

Schließlich ist es noch aus EP 0 448 374 B1 bekannt, zur Steigerung der Kapazität bei einem Kondensator polykristallines Silizium mit einer mikrorauhen Oberfläche zu verwenden. Durch diese mikrorauhe Oberfläche mit Korngrößen des Siliziums zwischen 30 und 50 A läßt sich die "Plattenfläche" des Kondensators ohne weiteres vergrößern, ohne zusätzlichen Platz auf der Chipfläche zu benötigen.

Wie bereits oben erwähnt wurde, ist der FIN-Stapelkondensator hinsichtlich der zu erzielenden Kapazitätswerte besonders vorteilhaft. Nimmt die zur Verfügung stehende Fläche auf dem Halbleiterchip aber weiter ab, so ist der Beitrag, den die Lamellen bzw. Rippen zur Kapazität des Kondensators insgesamt zu liefern vermögen, immer kleiner, so daß der durch die Lamellen bzw. Rippen bedingte Kapazitätsgewinn nicht unbedingt den zusätzlichen Aufwand rechtfertigt, der zur Herstellung dieser Rippen erforderlich ist.

Es ist daher Aufgabe der vorliegenden Erfindung, ein Verfahren zum Herstellen eines Kondensators für eine HalbleiterSpeicheranordnung anzugeben, die auf kleinem Raum ohne großen Aufwand die Erzielung relativ hoher Kapazitätswerte erlaubt.

Diese Aufgabe wird durch ein Verfahren gemäß Anspruch 1 gelöst, das sich durch die folgenden Schritte auszeichnet:
(a) Aufbringen eines selektiv ätzbaren Materials auf eine über ein Kontaktloch in einer Isolatorschicht mit einem Halbleiterkörper verbundene leitfähige Unterlage,
(b) Strukturieren des selektiv ätzbaren Materials,
(c) Aufbringen einer ersten leitfähigen Schicht, die mindestens einen Teil einer ersten Kondensatorelektrode bildet, auf das strukturierte Material,
(d) Strukturieren der ersten leitfähigen Schicht und Einbringen eines Loches in die das selektiv ätzbare Material bedeckende ersten leitfähige Schicht,
(e) Herausätzen des selektiv ätzbaren Materials, so daß unter der ersten leitfähigen Schicht ein Hohlraum entsteht,
(f) Überziehen der Innenfläche des Hohlraumes und der Außenfläche der ersten leitfähigen Schicht mit dielektrischen Schichten und
(g) Auftragen und Strukturieren einer zweiten leitfähigen Schicht, die eine zweite Kondesatorelektrode bildet, auf die dielektrische Schicht innerhalb und außerhalb des Hohlraumes.

Im obigen Schritt (b) kann zusammen mit dem Strukturieren des selektiv ätzbaren Materials auch die unter diesem selektiv ätzbaren Material liegende leitfähige Unterlage abgetragen werden, wobei die Isolatorschicht hier einen Atzstopp bildet. Alternativ wird dieser Teil der leitfähigen Unterlage im Schritt (d) zusammen mit einem Teil der ersten leitfähigen Schicht entfernt.

Bei der Herstellung eines Kondensators für "hoch ε" oder ferroelektrische Dielektrika wird unter der leitfähigen Schicht zusätzlich noch eine Barriereschicht aus beispielsweise Titannitrid auf der Isolatorschicht aus beispielsweise Siliziumnitrid vorgesehen. Anstelle von Titannitrid kann u.a. auch Rhodium verwendet werden.

Typische Abmessungen des erfindungsgemäß hergestellten Kondensators betragen etwa 150 bis 200 nm für den Durchmesser, 100 nm bis 2 µm für die Höhe und 10 bis 100 nm für die Schichtdicke der dielektrischen Schicht.

Weitere Ausgestaltungen der Erfindung ergeben sich aus den weiteren Ansprüchen.

Auf diese Weise wird ein Kondensator hergestellt mit einem Halbleiterkörper, auf dessen Oberfläche eine erste leitfähige Schicht, die eine erste Kondensatorelektrode bildet, und eine von-der ersten leitfähigen Schicht durch eine dielektrische Schicht getrennte zweite leitfähige Schicht, die auf der Oberfläche des Halbleiterkörpers kontaktiert ist und eine zweite Kondensatorelektrode bildet, vorgesehen sind, wobei die zweite leitfähige Schicht einen von der ersten leitfähigen Schicht geschaffenen Raum wenigstens teilweise ausfüllt.

Der Kondensator zeichnet sich darüber hinaus dadurch aus, daß die erste leitfähige Schicht als Raum einen wenigstens eine Öffnung aufweisenden Hohlraum bildet, auf dessen Innen- und Außenflächen auf der dielektrischen Schicht die über die wenigstens eine Öffnung untereinander zusammenhängende zweite leitfähige Schicht aufgetragen ist.

Gemäß einer Weiterbildung der vorliegenden Erfindung wird die erste leitfähige Schicht über ein in einer Isolierschicht vorgesehenes Kontaktloch mit dem Halbleiterkörper elektrisch verbunden. Eine derartige Kontaktierung ist zwar an sich bekannt. Sie ermöglicht aber bei dem erfindungsgemäß hergestellten Kondensator besondere Vorteile: die Gegenelektrode kann dann ohne weiteres nach einer Planarisierung der Oberfläche der Halbleiter-Speicheranordnung durch eine auf dieser geführte Leiterbahn kontaktiert werden, so daß die Anschlüsse des Kondensators im Halbleiterkörper bzw. auf einer auf dem Halbleiterkörper vorgesehenen Isolierschicht gelegen sind.

Weiterhin ist es zweckmäßig, die Oberfläche der ersten leitfähigen Schicht aufzurauhen, um so zu einer weiteren Steigerung der Kapazität des Kondensators beizutragen.

Als Halbleiterkörper wird vorzugsweise eine monokristalline Siliziumscheibe oder ein SOI-Substrat verwendet.

Für die erste und/oder die zweite leitfähige Schicht wird in bevorzugter Weise n- oder p-dotiertes polykristallines Silizium verwendet. Es sei aber angemerkt, daß hierfür auch andere Materialien in Betracht gezogen werden können.

Soll der Kondensator aus einem "hoch ε Material", wie z.B. Bariumstrontiumtitanat (BST), oder aus ferroelektrischem Material hergestellt werden, so besteht in vorteilhafter Weise die erste leitfähige Schicht aus einer Metallschicht, die ihrerseits auf eine Barriereschicht aus beispielsweise Titannitrid (TiN) aufgetragen ist. Für eine solche Metallschicht kann beispielsweise Platin (Pt) eingesetzt werden.

Für die Isolatorschicht mit dem Kontaktloch kann in bevorzugter Weise Siliziumnitrid verwendet werden. Dieses bildet dann beim Strukturieren der ersten leitfähigen Schicht einen Ätzstopp, wenn für diese erste leitfähige Schicht Silizium verwendet wird.

Für die dielektrische Schicht des Kondensators kann eine Isolierschicht aus Siliziumnitrid und/oder Siliziumdioxid eingesetzt werden, wobei in vorteilhafter Weise beispielsweise auch zwei durch eine Siliziumnitridschicht getrennte Siliziumdioxidschichten verwendbar sind (ONO-Struktur). Es ist auch möglich, hierfür Tantalpentoxid vorzusehen.

Für einen FRAM wird als dielektrische Schicht eine ferroelektrische Schicht verwendet, wie beispielsweise eine Schicht aus Strontiumwismuttantalat (SBT).

Nachfolgend wird die Erfindung anhand der Zeichnungen näher erläutert. Es zeigen:
- Fig. 1a bis f: Schnittbilder zur Erläuterung eines zwei verschiedene Varianten aufweisenden Verfahrens gemäß einem ersten Ausführungsbeispiel der Erfindung,
- Fig. 2a bis f: Schnittbilder zur Erläuterung eines zwei verschiedene Varianten aufweisenden Verfahrens gemäß einem zweiten Ausführungsbeispiel der Erfindung und
- Fig. 3a bis f: Schnittbilder zur Erläuterung eines zwei verschiedene Varianten aufweisenden Verfahrens gemäß einem dritten Ausführungsbeispiel der Erfindung.

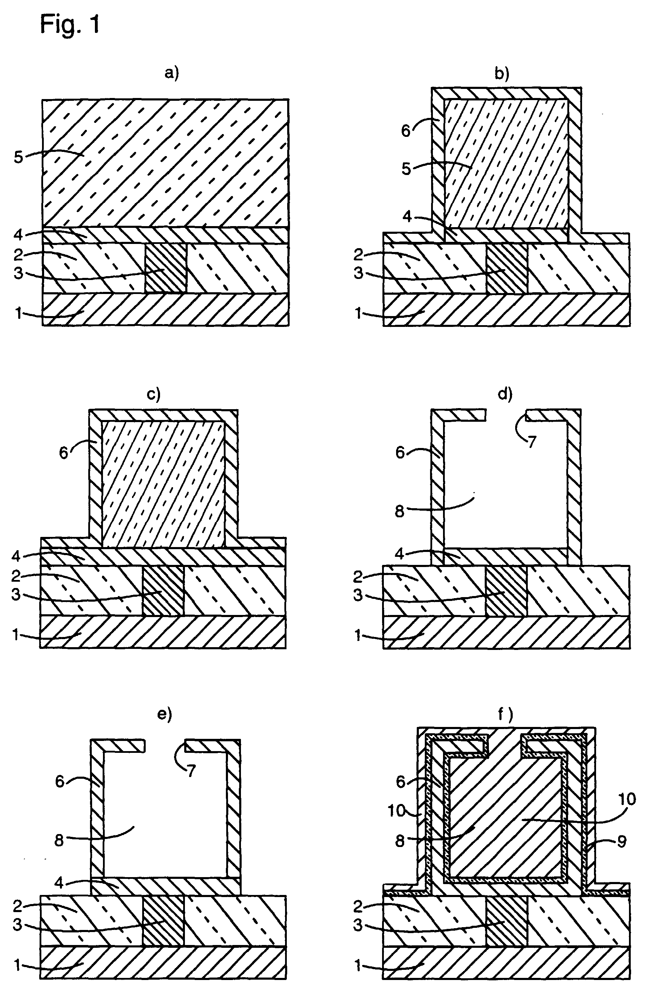

Fig. 1a zeigt ein Halbleitersubstrat 1 aus Silizium, auf dem eine Isolatorschicht 2 aus Siliziumnitrid vorgesehen ist. Diese Isolatorschicht 2 weist ein Kontaktloch 3 auf, über das eine leitfähige Schicht 4 aus beispielsweise dotiertem polykristallinem Silizium mit dem Halbleitersubstrat 1 in Verbindung steht. Das heißt, das Kontaktloch 3 ist mit dem Material der leitfähigen Schicht, also im vorliegenden Beispiel mit dotiertem polykristallinem Silizium, ausgefüllt.

Das Auftragen des polykristallinen Siliziums kann beispielsweise durch Gasphasenabscheidung (CVD) geschehen.

Anschließend wird auf die so hergestellte Anordnung eine zum Material der Isolatorschicht 2 selektiv ätzbare weitere Schicht 5 aus Siliziumdioxid (TEOS) aufgetragen. Für die Schichten 2 und 5 können auch andere Materialien gewählt werden. Diese Schichten sollten aber selektiv zueinander ätzbar sein.

Die Schichtdicke der weiteren Schicht 5 wird abhängig von der erwünschten Kapazität eingestellt. So kann diese Schichtdicke beispielsweise zwischen 100 nm und 2 µm liegen. Damit wird die in Fig. 1a gezeigte Anordnung erhalten.

Sodann wird, wie in Fig. 1b gezeigt ist, die weitere Schicht 5 durch beispielsweise reaktives Ionenätzen in die gewünschte Größe strukturiert. Bei dieser Strukturierung wird auch zusammen mit der weiteren Schicht 5 auch ein Teil der leitfähigen Schicht 4 abgetragen, so daß nur die unter der weiteren Schicht 5 liegende leitfähige Schicht 4 zurückbleibt. Anschließend wird eine leitfähige Schicht 6 aufgetragen, die aus dem gleichen Material wie die leitfähige Schicht 4 bestehen kann. Das heißt, im vorliegenden Ausführungsbeispiel wird für die leitfähige Schicht 6 wiederum dotiertes polykristallines Silizium verwendet.

Auf diese Weise wird auf der Oberfläche der Isolatorschicht 2 eine Struktur erhalten, bei der die quaderförmige oder zylinderförmige bzw. auch anders gestaltete weitere Schicht 5 allseitig durch die leitfähigen Schichten 4, 6 eingeschlossen ist, wie dies in Fig. 1b gezeigt ist.

Sodann wird die leitfähige Schicht 6 außerhalb des "Quaders" (bzw. der anders gestalteten Struktur) abgetragen, und im "Deckel" des Quaders wird in die leitfähige Schicht 6 ein Loch 7 eingebracht. Dies kann gegebenenfalls durch reaktives Ionenätzen geschehen. Durch dieses Loch 7 wird die weitere Schicht 5 im Quader, also im vorliegenden Ausführungsbeispiel die Schicht 5 aus Siliziumdioxid bzw. TEOS mit einer zu den leitfähigen Schichten 4, 6 selektiv Naßätzlösung, beispielsweise Flußsäure, herausgeätzt, so daß ein Hohlraum 8 entsteht. Damit liegt die in Fig. 1d gezeigte Struktur vor.

Die Innenflächen dieses Hohlraumes 8 sowie die Außenflächen der leitfähigen Schicht 6 werden sodann mit einer dielektrischen Schicht 9 aus beispielsweise ONO überzogen. Anschließend wird eine leitfähige Gegenelektrode 10 aus beispielsweise dotiertem polykristallinem Silizium so aufgebracht, daß diese auch den Hohlraum 8 wenigstens teilweise ausfüllt.

Die Fig. 1c und 1e zeigen eine Variante des soeben erläuterten Verfahrens: Bei der Strukturierung der weiteren Schicht 5 aus beispielsweise Siliziumdioxid (TEOS) wird die leitfähige Schicht 4 belassen und nicht abgeätzt, so daß die leitfähige Schicht 6 auch auf die leitfähige Schicht 4 außerhalb des "Quaders" aufgetragen wird (vgl. Fig. 1c). Dafür wird die leitfähige Schicht 4 außerhalb des Quaders zusammen mit der daraufliegenden leitfähigen Schicht 6 während deren Strukturierung zur Erzeugung des Loches 7 abgetragen, wie dies in Fig. 1e gezeigt ist.

Der Kondensator, der in Fig. 1f gezeigt ist, zeichnet sich durch eine große Oberfläche seiner Elektroden und damit durch eine große Kapazität aus. Bei diesem Kondensator wird in vorteilhafter Weise der Innenraum eines durch eine erste Elektrode gebildeten Quaders (bzw. einer anders gestalteten Struktur) ausgenutzt, um die Kondensatorfläche in erheblichem Ausmaß zu steigern. Lamellenartige Strukturen oder dergleichen, deren Beitrag zur Kondensatorfläche bei kleiner werdender Grundfläche immer geringer wird, werden dafür nicht verwendet.

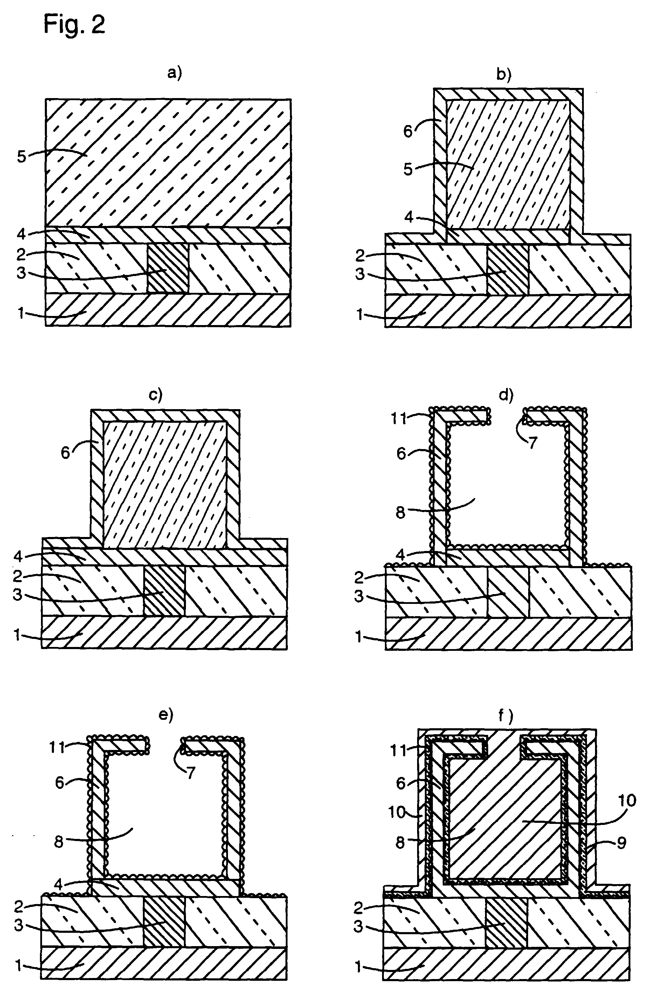

Fig. 2 zeigt ein anderes vorteilhaftes Ausführungsbeispiel des erfindungsgemäß hergestellten Kondensators bzw. Schritte zur Herstellung desselben. Dabei entsprechen die Fig. 2a bis 2f jeweils den Fig. 1a bis 1f.

Im Unterschied zu dem Ausführungsbeispiel der Fig. 1 verwendet jedoch das Ausführungsbeispiel der Fig. 2 (vgl. dort insbesondere die Fig. 2d bis 2f) ein sogenanntes aufgerauhtes bzw. "rugged" polykristallines Silizium, das eine vergrößerte Oberfläche 11 hat. Dieses polykristalline Silizium mit vergrößerter Oberfläche 11 kann beispielsweise durch Low pressure- bzw. Niederdruck-CVD (LPCVD) bei 500 bis 620°C und einem Druck von 1330 Pa - 1,3 Pa (10 bis 0,01 Torr) nach der Strukturierung des Hohlraumes 8 auf die Schichten 4 und 6 abgeschieden werden. Die übrigen Verfahrensschritte entsprechen dem Ausführungsbeispiel der Fig. 1.

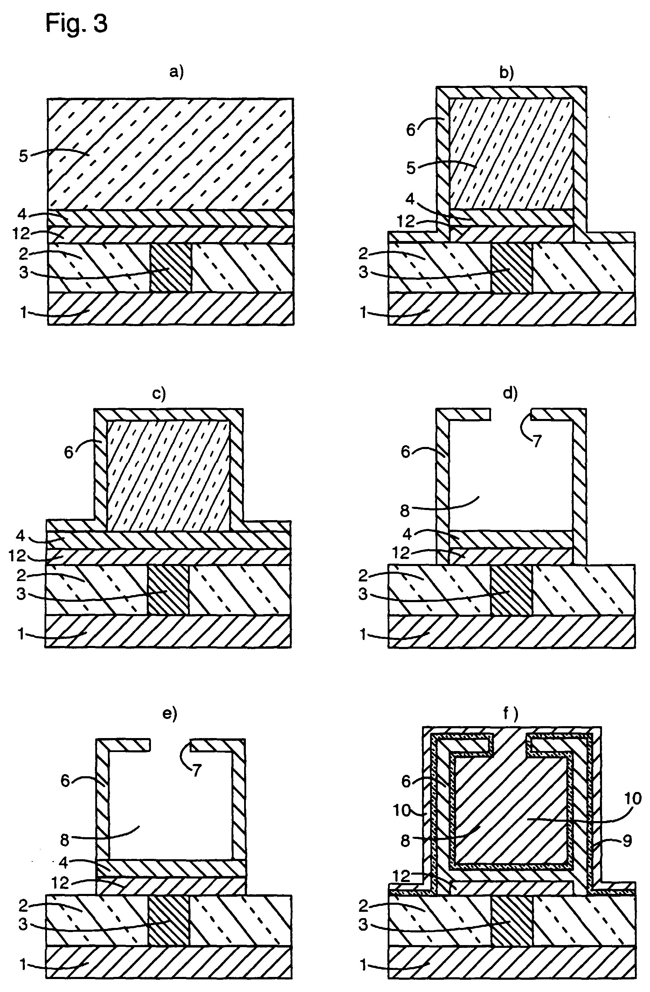

Die Fig. 3a bis 3f zeigen schließlich ein Verfahren zum Herstellen eines Kondensators für "hoch ε" oder Ferroelektrika, wobei die dielektrische Schicht 9 aus beispielsweise Bariumstrontiumtitanat oder Tantalpentoxid oder SBT, und nicht wie in den Fig. 1 und 2 aus ONO, besteht. Beim Ausführungsbeispiel der Fig. 3 wird außerdem auf die Isolatorschicht 2 mit dem Kontaktloch 3 eine Barriereschicht 12 aus beispielsweise Titannitrid (TiN) aufgetragen, auf der sodann die leitfähige Schicht 4 aus beispielsweise Platin gebildet wird. Die Schichten 12 und 4 können hier durch CVD oder Sputtern erzeugt werden.

Es schließt sich sodann wie in den Ausführungsbeispielen der Fig. 1a und 2a das Auftragen der selektiv ätzbaren, weiteren Schicht 5 aus beispielsweise Siliziumdioxid (TEOS) an, deren Schichtdicke wiederum entsprechend der erwünschten Kapazität festgelegt wird. Wie in den Ausführungsbeispielen der Fig. 1 und 2 wird diese weitere Schicht 5 strukturiert und mit einer leitfähigen Schicht 6 aus beispielsweise dem gleichen Material wie die Schicht 4, also Platin, überwachsen.

Die Barriereschicht 12 und die leitfähigen Schichten 4, 6 werden sodann mit Hilfe einer Maske strukturiert, und im Deckel des so entstandenen "Quaders" (oder anders gestalteten Struktur) wird ein Loch 7 in der leitfähigen Schicht 6 erzeugt. Durch dieses Loch 7 wird wiederum wie in den Beispielen der Fig. 1 und 2 die weitere Schicht 5, die im vorliegenden Ausführungsbeispiel aus Siliziumdioxid besteht, mit einer zur Schicht 4 bzw. 6 selektiven Naßätzlösung aus beispielsweise Flußsäure herausgeätzt.

Der Hohlraum 8, der durch die leitfähigen Schichten 6 und 4 gebildet wird, wird wie die Außenflächen der leitfähigen Schichten 6 mit einer dielektrischen Schicht 9 überzogen. Im vorliegenden Ausführungsbeispiel besteht diese dielektrische Schicht aus Bariumstrontiumtitanat oder SBT. Es können aber auch andere Ferroelektrika oder Tantalpentoxid gewählt werden. Es schließt sich sodann - wie in den Ausführungsbeispielen der Fig. 1 und 2 - das Aufbringen der leitfähigen Gegenelektrode 10 an, was beispielsweise durch CVD gesehen kann. Abschließend wird die Gegenelektrode strukturiert, wofür auch hier ein reaktives Ionenätzen eingesetzt werden kann.

Wie in den Ausführungsbeispielen der Fig. 1 und 2 ist es auch im Ausführungsbeispiel der Fig. 3 möglich, die Schichten 4 und 12 außerhalb der strukturierten weiteren Schicht 5 zusammen mit dieser abzutragen (Variante der Fig. 3b und 3d) oder aber die Schichten 4 und 12 außerhalb der strukturierten weiteren Schicht 5 zusammen mit der leitfähigen Schicht 6 zu entfernen (Variante der Fig. 3c und 3e).

Die Erfindung ermöglicht die Herstellung eines Kondensators mit sehr kleinen Abmessungen und dennoch großer Kondensatorfläche bei kleiner benötigter Grundfläche. Die dielektrische Schicht 9 kann eine Schichtdicke bis herab zu 20 nm haben.

Bei dem erfindungsgemäßen Verfahren wird erstmals in eine vorzugsweise quaderförmige Struktur aus den leitfähigen Schichten 4, 6, die zunächst mit dem Material der weiteren Schicht 5 gefüllt ist, das gegenüber dem Material der Schichten 4, 6 selektiv ätzbar ist, ein Loch eingebracht, um so in dem Quader durch Ätzen einen Hohlraum zu bilden, dessen Innenfläche dann zur Steigerung der Kondensatorfläche ausgenutzt wird. Das Loch 7 kann beispielsweise durch reaktives Ionenätzen gebildet werden.

## Patentansprüche

1. Verfahren zum Herstellen eines Kondensators für eine Halbleiter-Speicheranordnung,
**gekennzeichnet** durch die folgenden Schritte:
(a) Aufbringen eines selektiv ätzbaren Materials (5) auf eine über ein Kontaktloch (3) in einer Isolatorschicht (2) mit einem Halbleiterkörper (1) verbundene leitfähige Unterlage (4),
(b) Strukturieren des selektiv ätzbaren Materials (5),
(c) Aufbringen einer ersten leitfähigen Schicht (6), die mindestens einen Teil einer ersten Kondensatorelektrode bildet, auf das strukturierte Material (5),
(d) Strukturieren der ersten leitfähigen Schicht (6) und Einbringen eines Loches (7) in die das selektiv ätzbare Material bedeckende erste leitfähige Schicht (6),
(e) Herausätzen des selektiv ätzbaren Materials (5), so daß unter der ersten leitfähigen Schicht (6) ein Hohlraum (8) entsteht,
(f) Uberziehen der Innenfläche des Hohlraumes (8) und der Außenfläche der ersten leitfähigen Schicht (6) mit einer dielektrischen Schicht (9) und
(g) Auftragen und Strukturieren einer zweiten leitfähigen Schicht, die eine zweite Kondensatorelektrode (10) bildet, auf die dielektrische Schicht (9).

2. Verfahren nach Anspruch 1,
**dadurch gekennzeichnet,**
daß im Schritt (b) auch die vom strukturierten selektiv ätzbaren Material (5) freiliegenden Bereiche der leitfähigen Unterlage (4) abgetragen werden.

3. Verfahren nach Anspruch 1,
**dadurch gekennzeichnet,**
daß im Schritt (d) mit der ersten leitfähigen Schicht (6) auch die unter den abgetragenen Bereichen der ersten leitfähigen Schicht (6) liegenden Teile der leitfähigen Unterlage (4) entfernt werden.

4. Verfahren nach einem der Ansprüch 1 bis 3,
**dadurch gekennzeichnet,**
daß die erste leitfähige Schicht (4, 6) über ein in einer Isolatorschicht (2) vorgesehenes Kontaktloch (3) mit dem Halbleiterkörper (1) elektrisch verbunden wird.

5. Verfahren nach einem der Ansprüche 1 bis 4,
**dadurch gekennzeichnet,**
daß die Oberfläche der ersten leitfähigen Schicht (4, 6) aufgerauht ist.

6. Verfahren nach einem der Ansprüche 1 bis 5,
**dadurch gekennzeichnet,**
daß die erste leitfähige Schicht (4, 6) und/oder die zweite leitfähige Schicht (10) aus polykristallinem Silizium gebildet werden.

7. Kondensator nach einem der Ansprüche 1 bis 6,
**dadurch gekennzeichnet,**
daß die erste leitfähige Schicht (4, 6) aus einer Metallschicht gebildet wird, die auf eine Barriereschicht (12) aufgetragen wird.

8. Verfahren nach Anspruch 7,
**dadurch gekennzeichnet,**
daß die Metallschicht aus Platin und die Barriereschicht aus Titannitrid gebildet werden.

9. Verfahren nach Anspruch 4,
**dadurch gekennzeichnet,**
daß die Isolatorschicht (2) aus Siliziumnitrid gebildet wird.

10. Verfahren nach einem der Ansprüche 1 bis 9,
**dadurch gekennzeichnet,**
daß die dielektrische Schicht (9) aus Schichtenfolgen aus Siliziumnitrid und Siliziumdioxid (ONO) gebildet werden.

11. Verfahren nach Anspruch 7 oder 8,
**dadurch gekennzeichnet,**
daß die dielektrische Schicht (9) aus einer ferroelektrischen oder "hoch ε" Schicht gebildet wird.

12. Verfahren nach Anspruch 11,
**dadurch gekennzeichnet,**
daß die ferroelektrische Schicht aus Strontiumwismuttantalat gebildet wird

13. Verfahren nach Anspruch 7 oder 8,
**dadurch gekennzeichnet,**
daß die dielektrische Schicht aus Tantalpentoxid gebildet wird.
